(19) Europäisches Patentamt / European Patent Office / Office européen des brevets

(11) **EP 3 876 037 A1**

(12) **EUROPEAN PATENT APPLICATION**

(43) Date of publication:
08.09.2021 Bulletin 2021/36

(51) Int Cl.:
*G03F 7/20* (2006.01)  *G01N 21/95* (2006.01)
*G01N 21/956* (2006.01)

(21) Application number: 20161488.0

(22) Date of filing: 06.03.2020

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: ASML Netherlands B.V.
5500 AH Veldhoven (NL)

(72) Inventors:
• **TINNEMANS, Patricius Aloysius Jacobus**
5500 AH Veldhoven (NL)
• **WARNAAR, Patrick**
5500 AH Veldhoven (NL)

(74) Representative: **ASML Netherlands B.V.
Corporate Intellectual Property
P.O. Box 324
5500 AH Veldhoven (NL)**

(54) **METROLOGY METHOD AND DEVICE FOR MEASURING A PERIODIC STRUCTURE ON A SUBSTRATE**

(57) Disclosed is a method of measuring a periodic structure on a substrate and associated metrology tools therefor. The method comprises configuring an illumination numerical aperture profile and/or orientation of the periodic structure for a measurement based on a detection numerical aperture profile and a ratio of target pitch and said illumination wavelength such that at least a pair of complementary diffraction orders are captured within the detection numerical aperture profile; and measuring the periodic structure using the configured illumination numerical aperture profile and/or orientation of the periodic structure.

Fig. 7

**Description**

FIELD

The present invention relates to a metrology method and device for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

A metrology device may use computationally retrieved phase to apply aberration correction to an image captured by the metrology device. Such metrology devices are described as using coherent or partially coherent illumination. It would be desirable to use incoherent radiation in such a device; however this requires a much larger illumination NA.

SUMMARY

Embodiments of the invention are disclosed in the claims and in the detailed description.

In a first aspect of the invention there is provided a method of measuring a periodic structure on a substrate and having at least one periodic pitch, with illumination radiation having at least one wavelength, the method comprising: configuring an illumination numerical aperture and/or orientation of the periodic structure for a measurement based on a detection numerical aperture profile and a ratio of said pitches and said wavelength such that at least a pair of complementary diffraction orders are captured within the detection numerical aperture profile; and measuring the periodic structure using the configured illumination numerical aperture profile and/or orientation of the periodic structure.

In a second aspect of the invention there is provided a metrology device for measuring a periodic structure on a substrate and having at least one periodic pitch, with illumination radiation having at least one wavelength, the metrology device comprising: a detection numerical aperture profile; and a configurable illumination numerical aperture profile and/or substrate orientation which is configurable for a measurement based on the detection numerical aperture profile and a ratio of said pitch and said wavelength such that at least a pair of complementary diffraction orders are captured within the detection numerical aperture profile.

In a third aspect of the invention there is provided a metrology device for measuring a periodic structure on a substrate and having at least one periodic pitch, with illumination radiation having at least one wavelength, the metrology device comprising: a substrate support for holding the substrate, the substrate support being rotatable around its optical axis, the metrology device being operable to optimize an illumination numerical aperture profile by rotating the substrate around the optical axis in dependence on said ratio of pitch and wavelength.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 comprises a schematic diagram of a metrology device for use in measuring targets according to embodiments of the invention;
- Figure 7 illustrates (a) first illumination pupil and detection pupil profiles according to a first embodiment, (b) second illumination pupil and detection pupil profiles according to a second embodiment; and (c) third illumination pupil and detection pupil profiles according to a third embodiment.
- Figure 8 illustrates illumination pupil and detection pupil profiles for (a) an arrangement without wafer rotation; and (b) an arrangement with wafer rotation for six successive $\lambda/P$ ratios according to embodiments of the invention; and
- Figure 9 depicts a block diagram of a computer system for controlling a system and/or method as disclosed herein.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

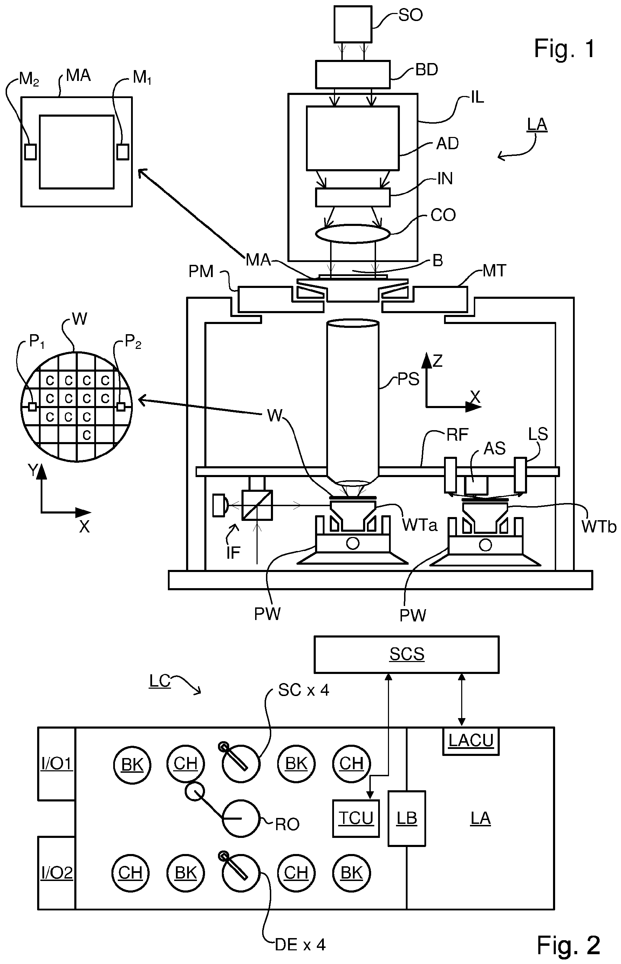

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

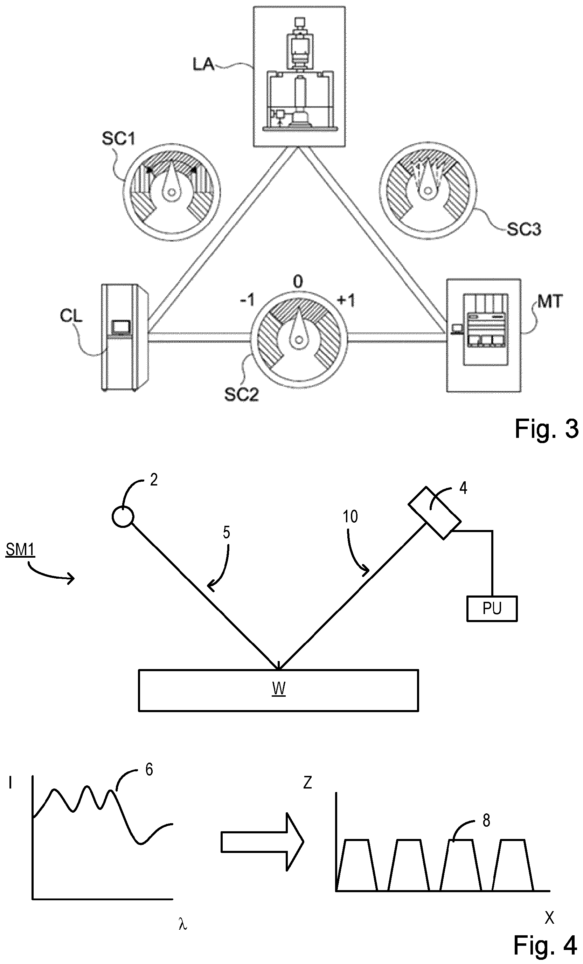

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

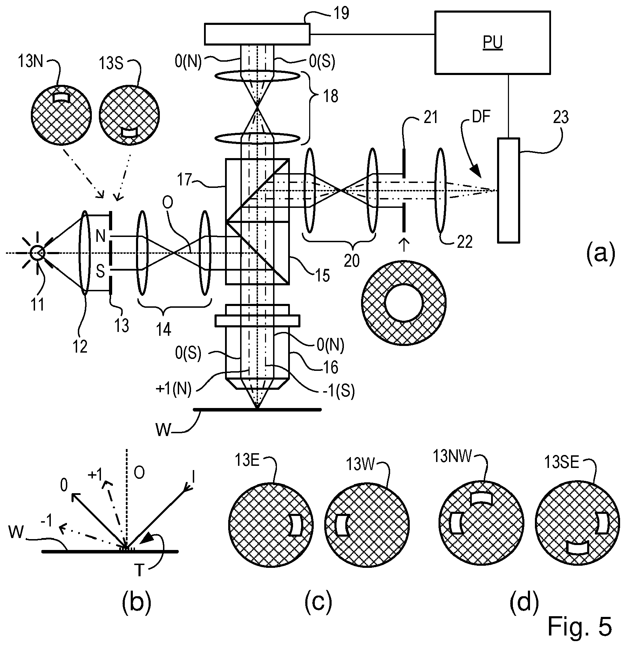

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16.

The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

The metrology tool just described requires low aberrations (for good machine-to-machine matching for example) and a large wavelength range (to support a large application range for example). Machine-to-machine matching depends (at least partly) on aberration variation of the (microscope) objective lenses being sufficiently small, a requirement that is challenging and not always met. This also implies that it is essentially not possible to enlarge the wavelength range without worsening the optical aberrations. Furthermore, the cost of goods, the volume and/or the mass of a tool is substantial, limiting the possibility of increasing the wafer sampling density (more points per wafer, more wafers per lot) by means of parallelization by providing multiple sensors to measure the same wafer simultaneously.

To address at least some of these issues, a metrology apparatus which employs a computational imaging/phase retrieval approach has been described in US patent publication US2019/0107781, which is incorporated herein by reference. Such a metrology device may use relatively simple sensor optics with unexceptional or even relatively mediocre aberration performance. As such, the sensor optics may be allowed to have aberrations, and therefore produce a relatively aberrated image. Of course, simply allowing larger aberrations within the sensor optics will have an unacceptable impact on the image quality unless something is done to compensate for the effect of these optical aberrations. Therefore, computational imaging techniques are used to compensate for the negative effect of relaxation on aberration performance within the sensor optics.

In such an approach, the intensity and phase of the target is retrieved from one or multiple intensity measurements of the target. The phase retrieval may use prior information of the metrology target (e.g., for inclusion in a loss function that forms the starting point to derive/design the phase retrieval algorithm). Alternatively, or in combination with the prior information approach, diversity measurements may be made. To achieve diversity, the imaging system is slightly altered between the measurements. An example of a diversity measurement is through-focus stepping, i.e., by obtaining measurements at different focus positions. Alternative methods for introducing diversity include, for example, using different illumination wavelengths or a different wavelength range, modulating the illumination, or changing the angle of incidence of the illumination on the target between measurements. The phase retrieval itself may be based on that described in the aforementioned US2019/0107781, or in patent application EP3480554 (also incorporated herein by reference). This describes determining from an intensity measurement, a corresponding phase retrieval such that interaction of the target and the illumination radiation is described in terms of its electric field or complex-valued field ("complex" here meaning that both amplitude and phase information is present). The intensity measurement may be of lower quality than that used in conventional metrology, and therefore may be out-of-focus as described. The described interaction may comprise a representation of the electric and/or magnetic field immediately above the target. In such an embodiment, the illuminated target electric and/or magnetic field image is modelled as an equivalent source description by means of infinitesimal electric and/or magnetic current dipoles on a (e.g., two-dimensional) surface in a plane parallel with the target. Such a plane may, for example be a plane immediately above the target, e.g., a plane which is in focus according to the Rayleigh criterion, although the location of the model plane is not critical: once amplitude and phase at one plane are known, they can be computationally propagated to any other plane (in focus, out of focus, or even the pupil plane). Alternatively, the description may comprise a complex transmission of the target or a two-dimensional equivalent thereof.

The phase retrieval may comprise modeling the effect of interaction between the illumination radiation and the target on the diffracted radiation to obtain a modelled intensity pattern; and optimizing the phase and amplitude of the electric field/complex-valued field within the model so as to minimize the difference between the modelled intensity pattern and the detected intensity pattern. More specifically, during a measurement acquisition, an image (e.g., of a target) is captured on detector (at a detection plane) and its intensity measured. A phase retrieval algorithm is used to determine the amplitude and phase of the electric field at a plane for example parallel with the target (e.g., immediately above the target). The phase retrieval algorithm uses a forward model of the sensor (e.g. aberrations are taken into account), to computationally image the target to obtain modelled values for intensity and phase of the field at the detection plane. No target model is required. The difference between the modelled intensity values and detected intensity values is minimized in terms of phase and amplitude (e.g., iteratively) and the resultant corresponding modelled phase value is deemed to be the retrieved phase. Specific methods for using the complex-valued field in metrology applications are described in PCT application PCT/EP2019/052658, also incorporated herein by reference.

However the illuminated computational imaging based metrology sensor such as described in the aforementioned publications is (mainly) designed for use with spatially coherent, or partially spatially coherent radiation. This results in the following drawbacks:

- The optical crosstalk performance is severely impacted by the fact that the (partial) coherent point spread function is substantial larger than the (near) incoherent point spread function. This limits the process variation performance due to the impact of variations in neighboring customer structures on the measured intensity asymmetry of the metrology target (e.g., from which overlay or focus is inferred). Also of note is that for a given identical detection NA, the incoherent resolution (limit) is twice as good as the coherent resolution (limit), which is (from a different but related viewpoint) also beneficial to reduce optical crosstalk.

- An (iterative) phase retrieval is required which requires a substantial amount of computational hardware, which increases the overall cost of goods of the metrology sensor. Also the phase retrieval is based on multiple diversity measurements, to provide the necessary information needed to retrieve the phase. It is estimated that practically speaking 2 to 10 diversity measurements are needed, increasing sensor acquisition time and/or complexity. For example, the diversity may be obtained by performing measurements sequentially at multiple focus levels. Obtaining stepwise defocused images is therefore slow, resulting in a slow measurement speed and low throughput. A simple calculation demonstrates this. Assuming that 5 through-focus images are taken for each combination of 4 (angular) directions and 5 (sequentially captured) wavelengths, and each image takes 1ms to capture, it will take about 100ms to measure each target. This does not include the time taken for moving the stages and switching wavelengths. In addition, the phase retrieval calculation (which is typically iterative) itself can be computationally intensive and take a long time to converge to a solution.

- Because, for a coherent illuminated computational imaging based metrology sensor, the detection NA (numerical aperture) is larger than the illumination NA, it is required to have a switchable illuminator which allows sequential measurement of the +1st and -1st diffraction orders for an x-target and y-target (hence the ability to switch between four illumination modes). In particular, darkfield imaging requires this, as the images of the +1st and -1st diffraction order can end up being located on top of one another for specific $\lambda$/P ratios. The alternative (which would not require a switchable illuminator) of having one (low NA) coherent illuminator and four (large NA) detection pupils, does not fit in the available k-space /pupil space/Fourier space/ solid angular space (the terms can be used synonymously) for the desired range of $\lambda$/P ratios. This increases the complexity, volume and cost of goods of the illumination, which is a disadvantage if one wants to parallelize multiple sensors to increase wafer sampling density. An additional drawback of this sequential measurement of the +1st and -1st diffraction orders, is that the sensor is not insensitive for (spatial average) temporal dose variations of the illumination source.

To address these issues, it is proposed to use a spatial incoherent or a close approximation (or at least multimode) illuminated computational imaging based metrology sensor. Such a metrology sensor may be a darkfield metrology sensor, e.g., for the measurement of asymmetry and parameters derived therefrom such as overlay and focus. For the remaining description, the term incoherent illumination will be used to describe spatially incoherent illumination or a close approximation thereof.

There are two conditions/assumptions under which monochromatic image formation may be assumed to be spatially incoherent; these two conditions/assumptions are:

$$\bar{O}\left(k'_x, k'_y, k_x, k_y\right) = \bar{O}\left(k'_x - k_x, k'_y - k_y\right)$$

$$\lim_{\mathcal{K} \to \mathbb{R}^2} \iint_{\mathcal{K}} \exp\left(i\frac{2\pi}{\lambda}\begin{bmatrix} k_x \\ k_y \end{bmatrix}^{\mathrm{T}} \cdot \begin{bmatrix} x' - x'' \\ y' - y'' \end{bmatrix}\right) dk_x, dk_y = \delta(x' - x'', y' - y'')$$

where $k_x, k_y$ are the x and y parameters in pupil space (k space), $\overline{O}(k_x, k_y)$ denotes the angular spectrum representation of the object (scalar) electric field function $O(x,y)$, $\lambda$ is the wavelength, $\iint_{\mathcal{K}} dk_x, dk_y$ denotes the integration over the Kohler type illumination pupil $\mathcal{K}$ and $\delta$ denotes the Dirac delta function. Note that in practice the illumination spatial coherence length will be larger than zero, i.e. the illuminator is not of the ideal Kohler type, but the above assumptions are still valid/made in that case also, to result in a computational model of the (near) spatial incoherent image formation. Note in case of non-monochromatic illumination, an extension of this incoherent imaging formalism is possible under a third assumption, which is that the target response does not (significantly) depend on the wavelength.

To aid implementation of spatially incoherent illumination, while suppressing the optical cross talk from structures (with different periodic pitches) near the overlay and/or focus target (for example), an optimized illumination arrangement is proposed in which the position of the illumination pupil is chosen dependent on a $\lambda$/P ratio of the illumination wavelength $\lambda$ (where $\lambda$ equals the central wavelength for example in case of a illumination bandwidth which is not small) and target pitch P, so as to ensure a pair of complementary higher diffraction orders (e.g., the +1 order and -1 order) coincide in pupil space (k-space) with the (e.g., fixed) detection pupil. In an embodiment, the illumination NA is set to be equal or (e.g., slightly) larger than the detection NA. Slightly larger may be up to 5% larger, up to 10% larger, up to 15% larger or up to 20% larger, for example. In an optional embodiment the pupil space may be shared by two pairs of diffraction orders (and therefore two incident illumination angular directions), one per direction to enable simultaneous detection in X and Y. Note that, while the teachings herein have particular applicability to incoherent systems (due to the larger illumination NA of such systems), it is not so limited and the concepts disclosed herein are applicable to coherent and partially or near coherent systems.

An additional benefit of using spatial incoherent illumination (or close approximation), is it enables the possibility of using an extended source, e.g., with a finite bandwidth; the use of a laser like source is not mandatory, as it practically would be for a spatial coherent illumination.

Simultaneously measuring both the +1st and -1st diffraction orders for either (or both) of the X-target or Y-target has the benefit that intensity noise and wavelength noise (e.g. mode hopping) is easier to suppress, and highly likely to be better suppressed.

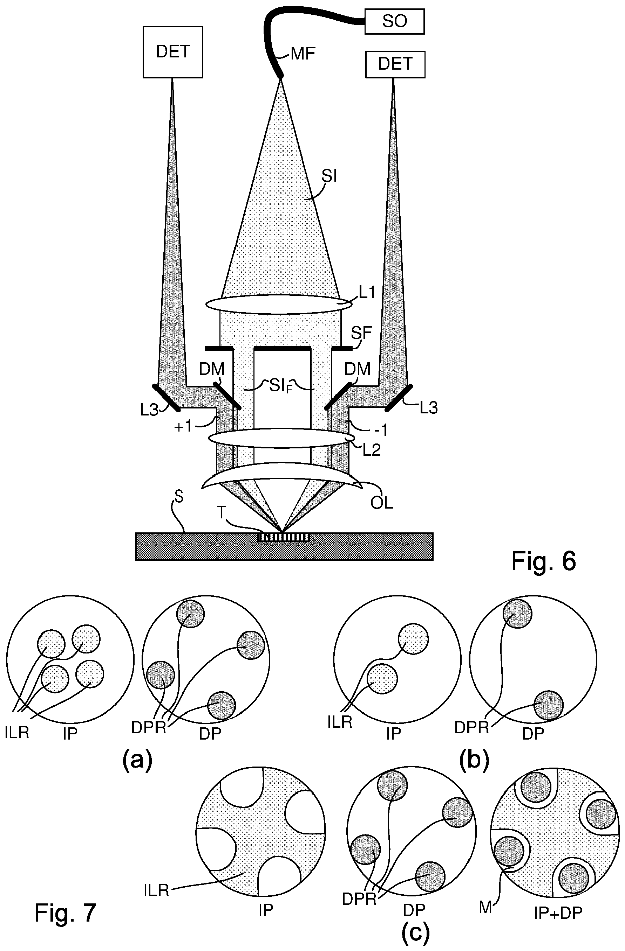

Figure 6 is a schematic illustration of such a metrology tool according to an embodiment. Note that this is a simplified representation and the concepts disclosed may be implemented in a metrology tool such as illustrated in Figure 5 (also a simplified representation), for example.

An Illumination source SO, which may be an extended and/or multi-wavelength source, provides source illumination SI (e.g., via a multimode fiber MF). An optical system, e.g., represented here by lens L1, L2 and objective lens OL comprises a spatial filter or mask SF which is located in a pupil plane (Fourier plane) of the objective lens OL (or access is provided to this pupil plane for filtering). The optical system projects and focuses the filtered source illumination $SI_F$ onto a target T on substrate S. As such a configurable illumination profile is provided such that the illumination pupil NA and position is defined by the filter SF. The diffracted radiation +1, -1 is guided by detection mirrors DM and lenses L3 to cameras/detectors DET (which may comprise one camera per diffracted order or a single camera or any other arrangement). As such, the detection pupil NA and position is defined by the area and position of detection mirrors DM.

In such an arrangement it may be that the detection mirrors and therefore detection pupil have a fixed size (NA) and position (as this is more practical physically). As such, it is proposed that the illumination pupil profile is configurable according to a particular target pitch (or strictly speaking and relevantly when illumination wavelength can be varied) wavelength-to-pitch ratio $\lambda$/P. The configurability of the illumination profile is such that the +1 and -1 diffracted orders are aligned with and substantially captured by the detection mirrors (e.g., one order per mirror); i.e., the position of +1 and -1 diffraction orders correspond and align with the detection pupil defined by the detection mirrors in pupil space. In an embodiment, the overlapping/alignment of the +1 and -1 orders may be such that the whole of the orders overlap the detection NA (e.g., and are captured by the detection mirrors). In other embodiments, it may be at least 95%, at least 90%, at least 80% or at least 70 % of the +1 and -1 orders overlap the detection NA (e.g., and are captured by the detection mirrors). In other arrangements, the relevant range is >= 1% or >= 10%. Assuming that the objective NA is 1, and a full open illumination profile is used (see Figure 7(c)), this would correspond to a detection NA of approximately 0.10 [sine-angle]. Of particular relevance is that the full detection region is filled with the corresponding diffraction order (assuming an infinitely large target, so that the diffraction order forms a Dirac delta function in angular space, i.e. in the detection pupil space). This is similar to a summation over the Kohler illuminator in the equation above. It is desirable that all angles which can propagate are present. As angular space is limited to 1 [sine-angle] (i.e. an angle of 90 degrees) it is not possible to sum from $-\infty$ to $+\infty$, which would be ideal from a mathematical point of view.

The configurability of the illumination pupil profile can be achieved by selection of a particular spatial filter SF as appropriate. Filters may be manually inserted or mounted to a filter wheel for example. Other filtering options include providing a spatial light modulator SLM in place of spatial filter SF, or even providing a spatially configurable light source for which its illumination profile can be directly configured. Any such method or any other method for obtaining and/or configuring a desired illumination profile may be used.

Figure 7(a) illustrates a configuration where the detection pupil DP comprises four detection pupil regions DPR (e.g., as defined by four detection mirrors), which may be configured for measurement of the positive and negative diffraction order information for an X-target and Y-target simultaneously. As such the illumination pupil IP comprises four illumination regions ILR to illuminate the target in two opposing (angular) directions per X and Y orientation, and is configured according to the $\lambda$/P ratio such that the resultant four first diffraction orders (i.e., +1, -1 per direction, one order captured per illumination region ILR) are each coincident in k-space (also referred to as Fourier space or angular space) with a respective detection pupil region DPR and are therefore captured by a respective detection mirror. As is known, the illumination pupil regions should not overlap with the detection pupil regions in pupil space (i.e., the pupil is divided into exclusive illumination regions and detection regions, although some space may be neither). In an alternative embodiment illustrated in Figure 7(b), the detection pupil DP has only two detection pupil regions DPR (e.g., two detection mirrors), which has the benefit of allowing for an increased detection NA, which reduces optical cross talk. As such, the illumination profile also has two illumination regions ILR to illuminate the target in two opposing (angular) directions. However, this would mean separate measurement in X and Y.

By way of a specific example, detection NA and the illumination NA may each comprise (e.g., in the example of Figure 7(a)): 4xNA=0.18 to 0.23. For example, it may be that the detection NA and illumination NA each comprises 4xNA=0.21. Note that in each case, the illumination NAs may be equal to, or (e.g., slightly) larger than the detection NAs. In the Figure 7(b) example, the detection NA may be e.g., 2xNA=0.23 to 0.27 (e.g., 2xNA=0.25), with a correspondingly larger illumination NA (e.g., which may be larger still, for example 2xNA=0.3). The illumination NA may be such that it overfills the detection NA for the +1, -1 detection orders. Overfilled in this context means that, for a target of infinite size, the diffraction order forms a Dirac delta pulse in the detection pupil plane. In practice, of course, targets must have finite size (e.g. 10 $\mu$m x 10 $\mu$m), so the energy of the diffraction orders spreads out in pupil space. Because of this, increasing the illuminator to have a larger NA than the detection NA may have advantages in that it may help the image formation to become closer to the incoherent extreme. In this respect, note the equations for the two conditions/assumptions under which monochromatic image formation may be assumed to be spatially incoherent described above; i.e., in which the spatial mutual coherence function collapses to a Dirac delta function allowing the image formation to be computed without the need of phase information of the target.

Figure 7(c) illustrates a further illumination arrangement which obviates the need for a configurable/programmable illuminator. In this embodiment, the illumination region ILR comprises the majority of the available k-space; e.g., all space except the detection pupil regions DPR and a margin M therebetween to avoid optical cross talk from the specular reflection (the zeroth order) of the target and/or surrounding structures. To better illustrate this margin, the Figure shows the illumination pupil and detection pupil overlaid IP+DP. In this specific example this margin has a width that equals 0.08 sine-angle, but may be, for example in a range of 0.05 to 0.12, 0.05 to 0.1 or 0.07 to 0.09. This filled illumination profile may have an NA larger than 0.9, or larger than 0.92 for example. This filled illumination profile may be used with the single direction detection pupil (two detection pupil regions) as illustrated in Figure 7(b).

Such a configuration for which both the illumination NA and detections NA(s) are fixed in size and position while still having optimized illumination for different $\lambda$/p ratios, enables a smaller sensor volume, mass and cost of goods. This is important in case of using multiples of such sensors in parallel to increase measurement speed and/or wafer sampling density (i.e., to measure all/more wafers from a lot and/or more metrology targets per wafer).

Having the illumination NA equal or slightly larger than the detection NA can be shown to be sufficient from a practical point of view for the resulting imaging formation to be close to a spatial incoherent imaging formation; e.g., up to the point where an incoherent imaging model can be used computationally to accurately compute/predict the detected camera image. For example, a relevant related discussion can be found in section 7.2 and equation 7.2-61 of the book "Statistical Optics" by J. Goodman (ISBN 1119009456, 9781119009450), which is incorporated herein by reference. Being able to compute/predict the detected camera image in this manner, allows correction for detection optics aberrations via a deconvolution (e.g., Wiener like), which has the benefit of being cheap to compute. In this manner, the full vectorial problem may be split into two scalar problems. Should the aberrations be such that there are zeros in the MTF (Modulation Transfer Function), then a regularization (such as an L1-Total-Variation regularization) may be used to cope with these zeros. Such regularization is described in the aforementioned EP3480554.

For an incoherent sensor the Modulation Transfer Function (MTF) is sloped, which means that the signal-to-noise ratio (S/N ratio) of the measured information depends on the spatial frequencies which make up the target. To maximize the S/N ratio of the resulting overlay (and/or focus) inference, it is preferable not to overly magnify a spatial frequency component with a poor S/N. Therefore the proposed deconvolution operation should not make the effective MTF flat again, as that will result in a suboptimal overlay S/N ratio. The optimal balancing of the S/N ratio and the deconvolution gain (for each spatial frequency component) results in a Wiener filter (as that does exactly that); and hence a "Wiener" like deconvolution.

Once captured, the camera image may be processed to infer the parameter of interest, e.g., overlay. Some processing operations performed on the image may include, for example, one or more of: edge detection, intensity estimation, periodic fit (if present in image). All of these operations can be (partially) written as a convolution operation (or a subsequent concatenation of multiple convolutions), e.g., region-of-interest kernel to weigh pixels for intensity estimation. The correction-kernel can be combined with all of these operations. Such an approach also makes it possible for the aberration correction operation to be made field position dependent. This way we can not only correct for field aberrations but also for pupil aberrations.

An example for flow of operations may be as follows, for a clean image $I_{clean}$ and a raw measurement $I_{raw}$:

$$I_{clean} = I_{raw} * K$$

where K denotes the correction-kernel and * denotes the convolution operator. Where the clean and raw images are processed with a region of interest kernel (ROI kernel) R, then:

$$I_{clean} * R = I_{raw} * (K * R)$$

The convolution of the correction kernel (K) and the kernel(s) for further mathematical operations, e.g. ROI kernel R, can be calculated outside of the critical measurement path, e.g. at the start of a measurement job. It is also generic for all measurements so needs to be done only once for each mathematical operation. This approach is likely to be much more time-efficient then convoluting every acquired image with the correction-kernel.

In an embodiment, the correction convolution kernel may be combined with a convolutional neural network. For example, the evaluation (or functionality of) the convolutions (e.g., aberration correction, PSF reshaping and ROI selection convolutions) may be implemented using a convolutional neural network, comprising one or many layers. This means that one convolution, having a large footprint kernel, may be broken up into multiple convolutions, with smaller foot sized kernels. In this way, the field dependence of the aberrations can be implemented/covered by a neural network.

An additional possibility is to include (a form of) Wavefront Coding, to enlarge (for example) the useable focus range and/or to optimize the performance for one or more other aspects. This encompasses the deliberate introduction (of designed) aberrations in the sensor optics which can be corrected for by the computational aberration correction. This reduces the sensitivity for focus variations, and hence effectively increases the useable focus range. For example, the following reference article comprise more details and is incorporated herein by reference: Dowski Jr, Edward R., and Kenneth S. Kubala. "Modeling of wavefront-coded imaging systems." In Visual Information Processing XI, vol. 4736, pp. 116-126. International Society for Optics and Photonics, 2002.

An additional possibility may comprise reshaping the (near) incoherent point spread function (PSF) shape by means of an apodization (which could be implemented in hardware, software or a hybrid thereof). An aberrated sensor results in a certain aberrated PSF. By means of the aberration correction, the PSF can be reshaped to that of an ideal/un-aberrated sensor. Additionally the optical cross talk may be reduced further by suppressing the sidelobes of the resulting PSF by means of applying an apodization. By way of specific example, a computational apodization may be applied, such that the resulting PSF has the shape of the Hanning windowing function.

For some diffraction based overlay techniques, a target may comprise different pitches in each of its layers. In such as case, the detection NA should be large enough so that one illumination ray/position enables the contribution of both pitches to be detected/captured (there should be coherent interference between the two pitches at detector/camera level).

It is further proposed to include a (e.g., programmable) rotation of the wafer around the optical axis of the sensor (or at least rotation of the target around the optical axis of the sensor). This can be used to increase/maximize the illumination and/or detection NAs and/or to increase the λ/P ratio which can be supported (by releasing further available k-space). Alternatively or in addition, such a rotation capability can be used to further suppress crosstalk from neighboring structures, as it will result in different location of the four (or two) illumination pupils with respect to one of the detection pupils.

In such an embodiment, therefore, it is proposed to use an illumination and detection pupil geometry optimized in combination with a wafer rotation, wherein one or both of the illumination geometry (e.g., as already described) and the wafer rotation depends on the $\lambda / P$ ratio.

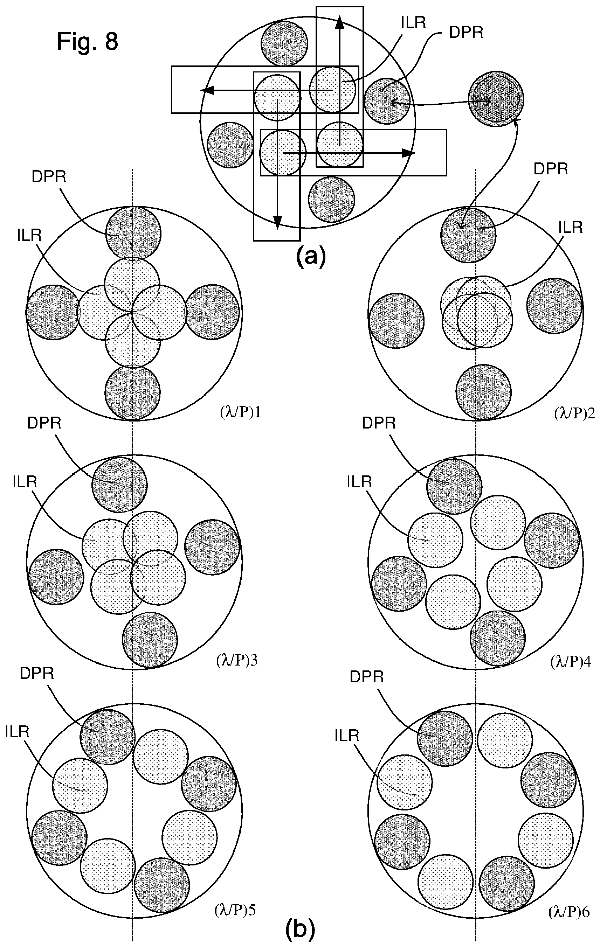

Figure 8 shows an example of how such a wafer rotation may be used to increase detection (and illumination) NA and/or increase the range of usable $\lambda / P$ ratios. Figure 8(a) shows the arrangement without wafer rotation (i.e., it is the illumination and detection profiles of Figure 7(a) overlaid). Note that the principles described in this section apply equally to any of the illumination and detection profiles of Figure 7 (e.g., Figure 7(b) or 7(c)) or any other arrangement within the scope of the disclosure. Without wafer rotation, for a fixed detection position DPR, the illumination positions ILR move along the arrows for an increasing λ/P ratio. This means that the detection and illumination NAs cannot be bigger than illustrated (as shown by the boxes) without significantly limiting the $\lambda / P$ ratios which can be used otherwise the illumination and detection NAs overlap. In particular a number of intermediate ratios (e.g., corresponding to an intermediate portion of each path indicated by the arrows where each the illumination position ILR is close to a nearest detection region DPR) would be unavailable.

Figure 8(b) shows six successive illumination profiles for respectively increasing $\lambda / P$ ratios (($\lambda / P$)1 - ($\lambda / P$)6), and where the illumination profile optimization includes wafer rotation around the optical axis (note that it looks as if the sensor is rotated instead of the wafer in the drawings). It can be seen that the illumination and detection NAs (for the same given overall NA) is larger in Figure 8(b), with a size comparison shown at the top of the Figure, while illumination and detection remains separate throughout the range of $\lambda / P$ ratios. The rotation might only be employed for some $\lambda / P$ ratios, e.g., to increase range for a given NA/detection profile.

It should also be appreciated that this concept of rotating the wafer according to $\lambda / P$ ratio, taking into account the periodic pitches of the surrounding structures (e.g., to weaken the contribution of these surrounding structures to the parameter of interest, such as intensity asymmetry, overlay, focus, etc.), so as to optimize illumination profile and/or $\lambda / P$ ratio range, can be employed on a metrology device independently of any other of the concepts disclosed herein, and for many different illumination and detection profiles and arrangements from those indicated.

In an embodiment, the rotation may be performed to optimize the margin M between the illumination and the detection pupils in a large illuminator embodiment such as that illustrated in Figure 7(c); e.g., to reduce the leakage of specular reflected light which carries no information but contributes to the photon shot noise.

Other options for maximizing detection NA and/or the allowable range of $\lambda / P$ ratios may comprise:

- Rotate the wafer around its (local) normal.
- Rotate the sensor around its optical central axis.
- Rotate the target (periodic pattern) direction on the wafer.
- Split the x-target and y-target measurement over two separate sensors.
- Split the +1st and -1st diffraction order measurement over two separate sensors.
- Division of the λ/P ratio range over two or more sensors, by means of splitting the wavelength range.
- Division of the λ/P ratio range over two or more sensors, by means of splitting the pitch range.
- Use of a solid/liquid immersion lens to increase the available k-space.
- Any hybrid/permutation/combination of the above (including a split over more than two separate sensors).

Note that the arrangement described above show only an example of how such a system may be implemented, and different hardware setups are possible. It may even be that the illumination and the detection are not necessarily through the same lens, for example.

During a measurement acquisition, components of the metrology system vary with respect to the preferred or optimum measurement condition, e.g. XYZ positioning, illumination/detection numerical aperture profile, central wavelength, bandwidth, intensity, etc. When this variation with respect to the optimum condition is known (e.g., via direct measurement or prediction), the acquired image can be corrected for this variation, e.g. via a deconvolution.

As throughput of a metrology system increases, more time is spend on settling of components after a (fast) move, e.g. XY-move. For a measurement sequence, the metrology system is programmed for specific set-points at which acquisitions are taken. Each scanning component will have its own trajectory during this sequence. An optimization can be performed to co-optimize all scanning components and other system limitations. The correction for variation of components during acquisition, as described above, can then be used to correct for all the known variations.

Measurements can also be acquired before and after the ideal acquisition moment in time. These measurements will have lower quality due to worse measurement conditions, but can still be used to retrieve relevant information. Measurements can be weighted with a quality KPI based on the deviation from the optimum measurement conditions.

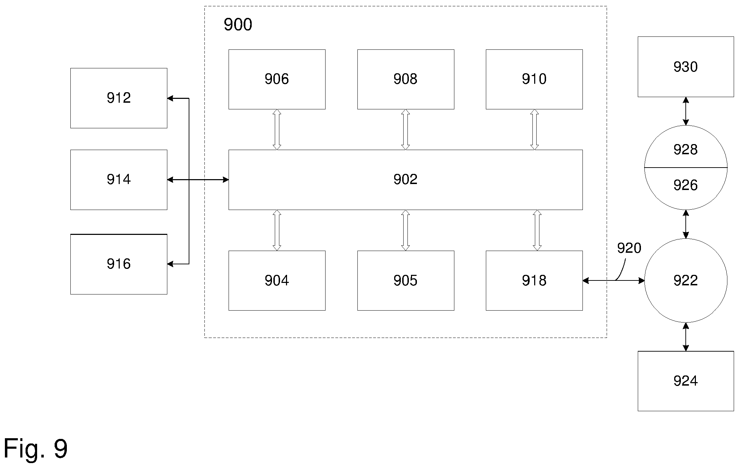

Figure 9 is a block diagram that illustrates a computer system 900 that may assist in implementing the methods and flows disclosed herein. Computer system 900 includes a bus 902 or other communication mechanism for communicating information, and a processor 904 (or multiple processors 904 and 905) coupled with bus 902 for processing information. Computer system 900 also includes a main memory 906, such as a random access memory (RAM) or other dynamic storage device, coupled to bus 902 for storing information and instructions to be executed by processor 904. Main memory 906 also may be used for storing temporary variables or other intermediate information during execution of instructions to be executed by processor 904. Computer system 900 further includes a read only memory (ROM) 908 or other static storage device coupled to bus 902 for storing static information and instructions for processor 904. A storage device 910, such as a magnetic disk or optical disk, is provided and coupled to bus 902 for storing information and instructions.

Computer system 900 may be coupled via bus 902 to a display 912, such as a cathode ray tube (CRT) or flat panel or touch panel display for displaying information to a computer user. An input device 914, including alphanumeric and other keys, is coupled to bus 902 for communicating information and command selections to processor 904. Another type of user input device is cursor control 916, such as a mouse, a trackball, or cursor direction keys for communicating direction information and command selections to processor 904 and for controlling cursor movement on display 912. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 900 in response to processor 904 executing one or more sequences of one or more instructions contained in main memory 906. Such instructions may be read into main memory 906 from another computer-readable medium, such as storage device 910. Execution of the sequences of instructions contained in main memory 906 causes processor 904 to perform the process steps described herein. One or more processors in a multiprocessing arrangement may also be employed to execute the sequences of instructions contained in main memory 906. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 904 for execution. Such a medium may take many forms, including but not limited to, non-volatile media, volatile media, and transmission media. Non-volatile media include, for example, optical or magnetic disks, such as storage device 910. Volatile media include dynamic memory, such as main memory 906. Transmission media include coaxial cables, copper wire and fiber optics, including the wires that comprise bus 902. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 904 for execution. For example, the instructions may initially be borne on a magnetic disk of a remote computer. The remote computer can load the instructions into its dynamic memory and send the instructions over a telephone line using a modem. A modem local to computer system 900 can receive the data on the telephone line and use an infrared transmitter to convert the data to an infrared signal. An infrared detector coupled to bus 902 can receive the data carried in the infrared signal and place the data on bus 902. Bus 902 carries the data to main memory 906, from which processor 904 retrieves and executes the instructions. The instructions received by main memory 906 may optionally be stored on storage device 910 either before or after execution by processor 904.

Computer system 900 also preferably includes a communication interface 918 coupled to bus 902. Communication interface 918 provides a two-way data communication coupling to a network link 920 that is connected to a local network 922. For example, communication interface 918 may be an integrated services digital network (ISDN) card or a modem to provide a data communication connection to a corresponding type of telephone line. As another example, communication interface 918 may be a local area network (LAN) card to provide a data communication connection to a compatible LAN. Wireless links may also be implemented. In any such implementation, communication interface 918 sends and receives electrical, electromagnetic or optical signals that carry digital data streams representing various types of information.

Network link 920 typically provides data communication through one or more networks to other data devices. For example, network link 920 may provide a connection through local network 922 to a host computer 924 or to data equipment operated by an Internet Service Provider (ISP) 926. ISP 926 in turn provides data communication services through the worldwide packet data communication network, now commonly referred to as the "Internet" 928. Local network 922 and Internet 928 both use electrical, electromagnetic or optical signals that carry digital data streams. The signals through the various networks and the signals on network link 920 and through communication interface 918, which carry the digital data to and from computer system 900, are exemplary forms of carrier waves transporting the information.

Computer system 900 may send messages and receive data, including program code, through the network(s), network link 920, and communication interface 918. In the Internet example, a server 930 might transmit a requested code for an application program through Internet 928, ISP 926, local network 922 and communication interface 918. One such downloaded application may provide for one or more of the techniques described herein, for example. The received code may be executed by processor 904 as it is received, and/or stored in storage device 910, or other non-volatile storage for later execution. In this manner, computer system 900 may obtain application code in the form of a carrier wave.

Further embodiments are disclosed in the subsequent list of numbered clauses:

1. A method of measuring a periodic structure on a substrate and having at least one periodic pitch, with illumination radiation having at least one wavelength, the method comprising:

configuring an illumination numerical aperture profile and/or orientation of the periodic structure for a measurement based on a detection numerical aperture profile and a ratio of said pitches and said wavelength such that at least a pair of complementary diffraction orders are captured within the detection numerical aperture profile; and

measuring the periodic structure using the configured illumination numerical aperture profile and/or orientation of the periodic structure.

2. A method as defined in clause 1, wherein the illumination numerical aperture profile comprises one or more illumination regions in Fourier space for illuminating the periodic structure in two opposing angular directions, and the detection numerical aperture profile comprises at least two separated detection regions in Fourier space, for capturing a respective one of said pair of complementary diffraction orders.

3. A method as defined in clause 2, wherein the illumination numerical aperture profile comprises one or more illumination regions in Fourier space, for illuminating the periodic structure in said two opposing angular directions for each of two periodic orientations of sub-structures comprised within the periodic structure, and the detection numerical aperture profile comprises four detection regions in Fourier space, for capturing a respective one of said pair of complementary diffraction orders for each of said periodic orientations.

4. A method as defined in clause 2 or 3, comprising a separate illumination region corresponding to a respective one of each detection region, and wherein each illumination region is the same size or larger than its corresponding detection region.

5. A method as defined in clause 4, wherein each illumination region is no more than 10% larger, or optionally, no more than 20% larger, or optionally, no more than 30% larger than its corresponding detection region.

6. A method as defined in clause 2 or 3, wherein said one or more illumination regions comprises a single illumination region.

7. A method as defined in clause 6, wherein the single illumination region comprises the available Fourier space other than the Fourier space used for the detection numerical aperture profile and a margin between the illumination numerical aperture profile and detection numerical aperture profile.

8. A method as defined in any of clauses 2 to 7, wherein each of said detection regions defines a numerical aperture no larger than 0.34

9. A method as defined in any preceding clause, wherein said configuring an illumination numerical aperture profile comprises spatial filtering the illumination radiation in a pupil plane of an objective lens, or equivalent plane thereof, to impose said illumination profile.

10. A method as defined in any preceding clause, wherein said illumination radiation comprises multimode radiation; or temporal and/or spatial incoherent radiation or an approximation thereof.

11. A method as defined in clause 10, comprising determining a complex-valued field to describe the periodic structure from a measured amplitude profile obtained during said measurement step.

12. A method as defined in clause 11, wherein said method comprises correcting said complex-valued field for aberrations in sensor optics used to perform the measurements.

13. A method as defined in clause 12, wherein said correcting said complex-valued field for aberrations is performed as a field position dependent correction.

14. A method as defined in clause 12 or 13, wherein said correcting is performed via a convolution of a raw image and correction kernel.

15. A method as defined in clause 14, wherein the correction kernel is combined with a convolutional neural network.

16. A method as defined in clause 14 or 15, wherein said convolution further comprises a convolution for each of one or more processing operations.

17. A method as defined any of clauses 11 to 16, wherein said method comprises correcting said complex-valued field to reshape the point spread function for aberrations in the point spread function due to the sensor optics used to perform the measurements.

18. A method as defined in any of clauses 11 to 17, further comprising correcting the complex-valued field for any deviation from an optimum measurement condition.

19. A method as defined in any of clauses 11 to 18, wherein said aberrations comprise deliberate wavefront modulating aberrations, and said method comprises correcting for the wavefront modulating aberrations so as to enlarge the useable focus range and/or depth of field of the sensor optics.

20. A method as defined in any preceding clause, wherein the illumination radiation comprises a wavelength band spanning multiple wavelengths, and said at least one wavelength comprises the central wavelength.

21. A method as defined in any preceding clause, wherein said configuring an orientation of the periodic structure comprises rotating the periodic structure around the optical axis in dependence on said ratio of pitch(es) and wavelength.

22. A method as defined in clause 21, wherein said rotating the periodic structure is performed by rotating the substrate round the optical axis.

23. A method as defined in clause 21 or 22, wherein said rotating the periodic structure is such that it enables an increased detection numerical aperture and/or illumination numerical aperture; and/or measurability of increased range of said pitches and/or with an increased range of said wavelengths than without rotation and/or better suppression of crosstalk from surrounding structures.

24. A metrology device being operable to perform the method of any of clauses 1 to 23.

25. A metrology device for measuring a periodic structure on a substrate and having at least one periodic pitch, with illumination radiation having at least one wavelength, the metrology device comprising:

    a detection numerical aperture profile; and
    a configurable illumination numerical aperture profile and/or substrate orientation which is configurable for a measurement based on the detection numerical aperture profile and a ratio of said pitch and said wavelength such that at least a pair of complementary diffraction orders are captured within the detection numerical aperture profile.

26. A metrology device as defined in clause 25, wherein the illumination numerical aperture profile comprises one or more illumination regions in Fourier space, for illuminating the periodic structure in two opposing angular directions, and the detection numerical aperture profile comprises at least two separated detection regions in Fourier space, for capturing a respective one of said pair of complementary diffraction orders.

27. A metrology device as defined in clause 25, wherein the illumination numerical aperture profile comprises one or more illumination regions in Fourier space, for illuminating the periodic structure in said two opposing angular directions for each of two periodic orientations of sub-structures comprised within the periodic structure, and the detection numerical aperture profile comprises four separated detection regions in Fourier space, for capturing a respective one of said pair of complementary diffraction orders for each of said periodic orientations.

28. A metrology device as defined in clause 26 or 27, comprising a separate illumination region corresponding to a respective one of each detection region, and wherein each illumination region is the same size or larger than its corresponding detection region.

29. A metrology device as defined in clause 28, wherein each illumination region is no more than 10% larger, or optionally, no more than 20% larger, or optionally, no more than 30% larger than its corresponding detection region.

30. A metrology device as defined in clause 26 or 27, wherein said one or more illumination regions comprises a single illumination region.

31. A metrology device as defined in clause 30, wherein the single illumination region comprises the available Fourier space outside that used for the detection numerical aperture profile and a margin between the illumination numerical aperture profile and detection numerical aperture profile.

32. A metrology device as defined in any of clauses 26 to 31, wherein each of said detection regions defines a numerical aperture no larger than 0.4.

33. A metrology device as defined in any of clauses 26 to 32, comprising detection mirrors or other optical elements, each of which defines the position and numerical aperture of a respective one of said detection regions.

34. A metrology device as defined in any of clauses 25 to 33, comprising a spatial filter to impose said illumination numerical aperture profile by filtering the illumination radiation in a pupil plane of an objective lens, or equivalent plane thereof.

35. A metrology device as defined in clause 34, wherein the spatial filter is physically replaceable depending on the ratio of pitch and wavelength.

36. A metrology device as defined in clause 35, wherein a plurality of spatial filters are mounted on a filter wheel.

37. A metrology device as defined in clause 34, wherein the spatial filter comprises a programmable spatial light modulator.

38. A metrology device as defined in any of clauses 25 to 33, comprising an illumination source with a configurable illumination profile to impose said illumination numerical aperture profile.

39. A metrology device as defined in any of clauses 25 to 38, wherein said illumination radiation comprises multimode radiation; or incoherent radiation or an approximation thereof.

40. A metrology device as defined in clause 39, comprising a processor configured to determine a complex-valued field to describe the periodic structure from a measured amplitude profile obtained during a measurement of the periodic structure.

41. A metrology device as defined in clause 40, comprising sensor optics for capturing said diffraction orders and said processor is further operable to correct said complex-valued field for aberrations in the sensor.

42. A metrology device as defined in clause 41, wherein said correcting said complex-valued field for aberrations is performed as a field position dependent correction.

43. A metrology device as defined in clause 41 or 42, wherein said processor is operable to perform said correction via a convolution of a raw image and correction kernel.

44. A metrology device as defined in clause 43, wherein the correction kernel is combined with a convolutional neural network.

45. A metrology device as defined in clause 43 or 44, wherein said convolution further comprises a convolution for each of one or more processing operations.

46. A metrology device as defined in any of clauses 41 to 45, wherein said processor is further operable to correct said complex-valued field to reshape the point spread function for aberrations in the point spread function due to the sensor optics used to perform the measurements.

47. A metrology device as defined in any of clauses 41 to 46, wherein said processor is further operable further comprising correcting the complex-valued field for any deviation from an optimum measurement condition.

48. A metrology device as defined any of clauses 41 to 47, wherein said aberrations comprise deliberate wavefront modulating aberrations, and said processor is further configured to correct for the wavefront modulating aberrations so as to enlarge the useable focus range and/or depth of field of the sensor.

49. A metrology device as defined in any of clauses 25 to 48, wherein the illumination radiation comprises a wavelength band spanning multiple wavelengths, and said at least one wavelength comprises the central wavelength.

50. A metrology device as defined in any of clauses 25 to 49, comprising a substrate support for holding the substrate, the substrate support being rotatable around its optical axis, the metrology device being operable to configure the substrate orientation at least in part by rotating the substrate around the optical axis in dependence on said ratio of pitch and wavelength.

51. A metrology device as defined in clause 50, wherein said rotating the substrate is such that it enables an increased detection numerical aperture and/or illumination numerical aperture; and/or measurability of increased range of said pitches and/or with an increased range of said wavelengths than without rotation.

52. A metrology device as defined in any of clauses 25 to 51, comprising an illumination source for providing said illumination radiation.

53. A metrology device for measuring a periodic structure on a substrate and having at least one periodic pitch, with illumination radiation having at least one wavelength, the metrology device comprising:

a substrate support for holding the substrate, the substrate support being rotatable around its optical axis, the metrology device being operable to optimize an illumination numerical aperture profile by rotating the substrate around the optical axis in dependence on said ratio of pitch and wavelength.

54. A metrology device as defined in clause 55, wherein said rotating the substrate is such that it enables an increased detection numerical aperture and/or illumination numerical aperture; and/or measurability of increased range of said pitches and/or with an increased range of said wavelengths than without rotation.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1.  A method of measuring a periodic structure on a substrate and having at least one periodic pitch, with illumination radiation having at least one wavelength, the method comprising:

    configuring an illumination numerical aperture profile and/or orientation of the periodic structure for a measurement based on a detection numerical aperture profile and a ratio of said pitches and said wavelength such that at least a pair of complementary diffraction orders are captured within the detection numerical aperture profile; and
    measuring the periodic structure using the configured illumination numerical aperture profile and/or orientation of the periodic structure.

2.  A method as claimed in claim 1, wherein the illumination numerical aperture profile comprises one or more illumination regions in Fourier space for illuminating the periodic structure in two opposing angular directions, and the detection numerical aperture profile comprises at least two separated detection regions in Fourier space, for capturing a respective one of said pair of complementary diffraction orders.

3.  A method as claimed in claim 2, wherein the illumination numerical aperture profile comprises one or more illumination regions in Fourier space, for illuminating the periodic structure in said two opposing angular directions for each of two periodic orientations of sub-structures comprised within the periodic structure, and the detection numerical aperture profile comprises four detection regions in Fourier space, for capturing a respective one of said pair of complementary diffraction orders for each of said periodic orientations.

4.  A method as claimed in claim 2 or 3, comprising a separate illumination region corresponding to a respective one of each detection region, and wherein each illumination region is the same size or larger than its corresponding detection region and, optionally, each illumination region is no more than 30% larger than its corresponding detection region.

5. A method as claimed in claim 2 or 3, wherein said one or more illumination regions comprises a single illumination region.

6. A method as claimed in claim 5, wherein the single illumination region comprises the available Fourier space other than the Fourier space used for the detection numerical aperture profile and a margin between the illumination numerical aperture profile and detection numerical aperture profile.

7. A method as claimed in any preceding claim, wherein said configuring an illumination numerical aperture profile comprises spatial filtering the illumination radiation in a pupil plane of an objective lens, or equivalent plane thereof, to impose said illumination profile.

8. A method as claimed in any preceding claim, wherein said illumination radiation comprises multimode radiation; or temporal and/or spatial incoherent radiation or an approximation thereof.

9. A method as claimed in claim 8, comprising determining a complex-valued field to describe the periodic structure from a measured amplitude profile obtained during said measurement step.

10. A method as claimed in claim 9, wherein said method comprises correcting said complex-valued field for aberrations in sensor optics used to perform the measurements.

11. A method as claimed in claim 10, wherein said correcting said complex-valued field for aberrations is performed as a field position dependent correction.

12. A method as claimed in claim 10 or 11, wherein said correcting is performed via a convolution of a raw image and correction kernel.

13. A method as claimed any of claims 9 to 12, wherein said method comprises correcting said complex-valued field to reshape the point spread function for aberrations in the point spread function due to the sensor optics used to perform the measurements.

14. A method as claimed in any preceding claim, wherein said configuring an orientation of the periodic structure comprises rotating the periodic structure around the optical axis in dependence on said ratio of pitch(es) and wavelength.

15. A metrology device for measuring a periodic structure on a substrate and having at least one periodic pitch, with illumination radiation having at least one wavelength, the metrology device comprising:

a detection numerical aperture profile; and
a configurable illumination numerical aperture profile and/or substrate orientation which is configurable for a measurement based on the detection numerical aperture profile and a ratio of said pitch and said wavelength such that at least a pair of complementary diffraction orders are captured within the detection numerical aperture profile.

Fig. 1

Fig. 2

LA

SC1

SC3

CL

0
-1    +1

MT

SC2

Fig. 3

2

4

5

10

SM1

PU

W

I

6

Z

8

λ

X

Fig. 4

Fig. 5

Fig. 6

Fig. 7

Fig. 8

(a)

(b)

DPR

ILR

(λ/P)1

DPR

ILR

(λ/P)2

DPR

ILR

(λ/P)3

DPR

ILR

(λ/P)4

DPR

ILR

(λ/P)5

DPR

ILR

(λ/P)6

Fig. 9

Europäisches
Patentamt

European
Patent Office

Office européen
des brevets

## EUROPEAN SEARCH REPORT

Application Number

EP 20 16 1488

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/206703 A1 (BHATTACHARYYA KAUSTUVE [NL] ET AL) 16 August 2012 (2012-08-16) | 1-3,15 | INV. G03F7/20 G01N21/95 G01N21/956 |
| A | * paragraphs [0089] - [0090], [0095] - [0103], [0134] - [0138]; claim 1n; figures 7,13a-15b * | 4-14 | |
| X | WO 2015/009739 A1 (KLA TENCOR CORP [US]) 22 January 2015 (2015-01-22) | 1-4,15 | |
| A | * paragraphs [0018] - [0020], [0029], [0031] - [0043], [0059], [0061]; figures 2,3E,6A-8B, 12 * | 5-14 | |
| A,D | US 2019/107781 A1 (TINNEMANS PATRICIUS ALOYSIUS JACOBUS [NL] ET AL) 11 April 2019 (2019-04-11) * paragraphs [0059] - [0097] * | 9-13 | |
| A | US 2016/061750 A1 (DEN BOEF ARIE JEFFREY [NL] ET AL) 3 March 2016 (2016-03-03) * paragraphs [0062] - [0078] * | 1-15 | |

TECHNICAL FIELDS
SEARCHED (IPC)

G03F
G01N

The present search report has been drawn up for all claims

| Place of search | Date of completion of the search | Examiner |
|---|---|---|
| Munich | 11 September 2020 | Roesch, Guillaume |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 16 1488

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2020

| Patent document cited in search report | Publication date | Patent family member(s) | Publication date |
|---|---|---|---|
| US 2012206703 A1 | 16-08-2012 | CN 102636963 A | 15-08-2012 |
| | | IL 217843 A | 30-11-2016 |
| | | JP 5280555 B2 | 04-09-2013 |
| | | JP 2012169617 A | 06-09-2012 |
| | | KR 20120092517 A | 21-08-2012 |
| | | TW 201245895 A | 16-11-2012 |
| | | US 2012206703 A1 | 16-08-2012 |
| WO 2015009739 A1 | 22-01-2015 | JP 6486917 B2 | 20-03-2019 |
| | | JP 6745367 B2 | 26-08-2020 |
| | | JP 2016527501 A | 08-09-2016 |
| | | JP 2019078773 A | 23-05-2019 |
| | | KR 20160034343 A | 29-03-2016 |
| | | KR 20200008043 A | 22-01-2020 |
| | | TW 201522942 A | 16-06-2015 |
| | | WO 2015009739 A1 | 22-01-2015 |
| US 2019107781 A1 | 11-04-2019 | CN 111527373 A | 11-08-2020 |
| | | KR 20200052355 A | 14-05-2020 |
| | | TW 201925922 A | 01-07-2019 |
| | | US 2019107781 A1 | 11-04-2019 |
| | | WO 2019068459 A1 | 11-04-2019 |
| US 2016061750 A1 | 03-03-2016 | CN 107924132 A | 17-04-2018 |
| | | KR 20170044720 A | 25-04-2017 |
| | | TW 201625935 A | 16-07-2016 |
| | | US 2016061750 A1 | 03-03-2016 |
| | | WO 2016030205 A1 | 03-03-2016 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 20190107781 A
- EP 3480554 A
- EP 2019052658 W

**Non-patent literature cited in the description**

- **J. GOODMAN.** Statistical Optics
- Modeling of wavefront-coded imaging systems. **DOWSKI JR ; EDWARD R. ; KENNETH S. KUBALA.** Visual Information Processing XI. International Society for Optics and Photonics, 2002, vol. 4736, 116-126